# FASCICULE DE BREVET EUROPEEN

(11) **EP 3 016 020 B1**
(45) Date de publication et mention de la délivrance du brevet: **16.05.2018**
(21) Numéro de dépôt: 15192237.4
(22) Date de dépôt: 30.10.2015
(51) Int. Cl.: G06K 7/00, G07F 7/08

(54) **CARTE DE CIRCUIT IMPRIMÉ**
LEITERPLATTE
PRINTED CIRCUIT BOARD

(30) Priorité: 03.11.2014 FR 1460599
(43) Date de publication de la demande: 04.05.2016
(73) Titulaire: Ingenico Group, 75015 Paris (FR)
(72) Inventeur: BONNET, Eric, 26120 MALISSARD (FR)
(74) Mandataire: Vidon Brevets & Stratégie

(56) Documents cités:
- CN-U- 202 904 762
- FR-A1- 2 795 845
- FR-A1- 2 992 094
- KR-A- 20140 050 168

## Description

### 1. Domaine

La présente divulgation se rapporte au domaine des terminaux de paiement. La présente divulgation se rapporte plus particulièrement au domaine des terminaux de paiement dits fixes. La présente divulgation se rapporte à un terminal de paiement dit fixe dans lequel l'architecture du terminal est améliorée afin de faciliter la fabrication, réduire est coûts et faciliter l'usage du terminal de paiement.

### 2. Art Antérieur

Dans le domaine des terminaux de paiement, on distingue deux classes de terminal. Les terminaux de paiement dits « fixes et les terminaux de paiement dits « mobiles ou « nomades ». Principalement, ces deux classes de terminal se distinguent l'une de l'autre notamment par le type d'alimentation électrique utilisé et par la connectique disponible. Un terminal « nomade » est destiné à être embarqué par un professionnel lors de ses déplacements (par exemple un taxi, un médecin, etc.). À cet effet, il comprend une source d'alimentation autonome (batterie) et une connectivité que l'on qualifie de sans fil (GPRS, WIFI, Bluetooth, etc.). Au final, un terminal nomade est souvent un objet plutôt léger et compact. Il existe par ailleurs des normes qui permettent de définir un terminal de paiement en termes de compacité.

À contrario, un terminal fixe est souvent un objet comprenant une connectivité plus étendue et des fonctions complémentaires. Un terminal fixe se caractérise principalement d'une part par sa connectivité filaire. En effet, en plus de disposer d'une éventuelle connectivité sans fil, le terminal fixe comprend une connectivité filaire : il s'agit par exemple d'une prise RJ45 pour un accès à un réseau local, d'une prise RJ11 pour accès à un réseau téléphonique RTC, d'un ou plusieurs ports USB, d'un ou plusieurs ports de communication. L'ensemble de cette connectique filaire est accessible au dos du terminal, en ôtant une trappe.

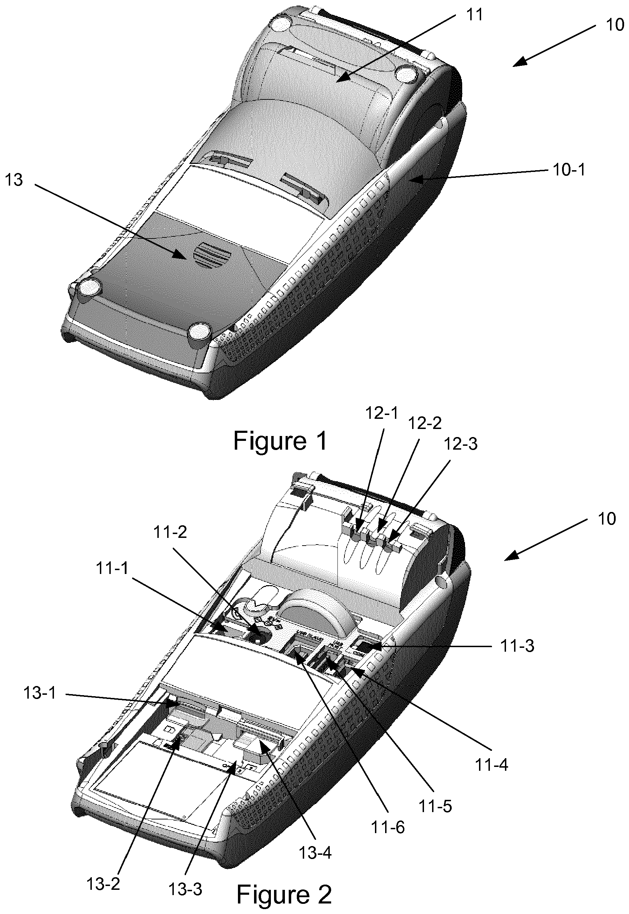

Une telle architecture est décrite en relation avec les figures 1 et 2 représentent un exemple de terminal de paiement (10) dont le demi boitier inférieur est visible (10-1). Ces figures ne sont bien entendu pas limitatives du point de vue de l'étendue de la présente divulgation et ne servent qu'à exposer un état de la technique afin de comprendre les problèmes posés. Les figures 1 et 2 représentent le dos d'un terminal de paiement fixe (10) de l'art antérieur. Il comprend une trappe (11) d'accès à un ensemble de prises (11-1, 11-2, 11-3, 11-4, 11-5, 11-6) permettant de connecter des câbles, notamment un câble d'alimentation, un câble RJ45, un câble RJ11, deux câbles USB. En fonctionnement, les câbles sont connectés aux différentes prises et prennent place dans des goulottes de positionnement (12-1, 12-2, 12-3). En mode d'utilisation, la trappe (11) est refermée et les câbles sortent du terminal de manière sensiblement parallèle au plan de pose du terminal de paiement. Le terminal comprend également une deuxième trappe (13), d'accès à un ensemble de connecteurs (13-1, 13-2, 13-3, 13-4). Il s'agit par exemple de connecteurs dits SAM ou SIM. Il s'agit également de connecteurs pour carte SD ou micro SD (13-1). Les cartes SAM et SIM qui peuvent être insérées à cet emplacement sont utilisées par exemple pour des besoins professionnels : il peut s'agir de la carte professionnelle d'un dentiste ou d'un médecin. Une carte SIM peut être insérée pour des besoins de communication : il peut s'agir d'une carte d'identification pour un opérateur téléphonique (communication GPRS) afin que le terminal puisse effectuer certaines transactions.

Comme on peut le constater sur la figure 1 et la figure 2, ces connecteurs sont positionnés en chevauchement. L'insertion des cartes SIM, SAM ou micro SD dans ces connecteurs n'est pas aisée. D'un point de vue général, un terminal de ce type pose plusieurs problèmes. Le premier problème est relatif à l'encombrement de ce type de terminal, lié à sa connectique complète. Un autre problème de ce type de terminal est lié à la présence de deux trappes : une trappe pour la connectique et une trappe pour les connecteurs : la présence de ces deux trappes augmente fortement le coût de fabrication du terminal. Par ailleurs, à cause de cette architecture, le demi-demi boitier inférieur du terminal est une pièce difficile et couteuse à produire.

Enfin, cette architecture pose un problème ergonomique : l'insertion et le retrait des cartes SIM et SAM est compliqué par le peu de place disponible. Ces différentes cartes sont situées dans des plans d'insertion différents. Par exemple, certains volumes ne facilitent pas l'accès à certaines zones d'insertion.

Le document coréen n°20140050168 divulgue une configuration fonctionnelle d'un terminal de paiement. Le document français FR2992094 divulgue des terminaux paiements sécurisés. Le document CN202904762 portant sur un terminal de paiement ayant un clavier à membrane. Ces documents ne proposent pas de solutions au problème relatif à l'optimisation de l'utilisation de l'espace dans un terminal de paiement.

### 3. Résumé

Le terminal de la présente divulgation ne présente pas ces problèmes de l'art antérieur. En effet, la présente divulgation se rapporte à une carte de circuit imprimé et un terminal de paiement intégrant une telle carte.

Plus particulièrement, la divulgation se rapporte à une carte de circuit imprimé principale d'un terminal de paiement sur laquelle est assemblé une pluralité de composants, dite carte mère. Selon la divulgation, lesdits composants de ladite pluralité de composants sont assemblés sur ladite carte mère en fonction de la hauteur desdits composants, de sorte que les composants de plus grande hauteur soient situés à une première extrémité de la carte et les composants de plus petite hauteur soit situés à une deuxième extrémité de la carte.

Selon une caractéristique particulière, ladite carte de circuit imprimé prend sensiblement la forme d'un rectangle divisé en au moins une première zone et au moins une deuxième zone, ladite première zone comprenant des composants dont la hauteur excède un seuil déterminé.

Selon une caractéristique particulière, lesdits composants de la première zone sont des composants de connexion filaires.

Selon une caractéristique particulière, ladite deuxième zone comprend des composants de connexion de cartes SIM ou SAM.

Selon une caractéristique particulière, ladite carte de circuit imprimé comprend en outre au moins une troisième zone comprenant des composants dont la hauteur se situe en deçà d'un plafond prédéterminé.

Selon une caractéristique particulière, ladite carte de circuit imprimé comprend en outre au moins un connecteur de carte optionnelle.

Selon une caractéristique particulière, ladite carte de circuit imprimé est conformée pour recevoir, au-dessus d'une zone recevant des composants dont la hauteur se situe en deçà d'un plafond prédéterminé, une carte optionnelle connectée à un connecteur spécifique de la carte de circuit imprimé.

Selon une caractéristique particulière, la hauteur des composants des composants de connexion de cartes SIM ou SAM de ladite deuxième zone est calculée de sorte que lesdits composants de connexion de cartes SIM ou SAM de ladite deuxième zone ait une hauteur sensiblement identique à des composants de même nature, qui sont montés sur une carte optionnelle qui connectée à un connecteur spécifique de la carte de circuit imprimé située dans une zone, au voisinage de ladite deuxième zone.

Selon un autre aspect, la divulgation se rapporte également à un demi-boitier inférieur d'un terminal de paiement comprenant un unique plan d'insertion d'une pluralité de module de traitement de données (SIM, SAM, Micro SD).

Selon un autre aspect, ladite divulgation se rapporte également à un terminal de paiement comprenant une carte de circuit imprimé telle que décrite précédemment.

### 4. Figures

D'autres caractéristiques et avantages apparaîtront plus clairement à la lecture de la description suivante d'un mode de réalisation particulier de la divulgation, donné à titre de simple exemple illustratif et non limitatif, et des dessins annexés, parmi lesquels :
- la figure 1, déjà commentée, est une vue isométrique de dessous d'un terminal de paiement de l'art antérieur dans laquelle dans laquelle deux trappes sont utilisées pour refermer le boitier ;
- la figure 2, déjà commentée, est une vue isométrique de dessous du même terminal qu'en figure 1, dans laquelle dans laquelle la deux trappes les deux trappes sont ôtées et laissent apparaître les éléments de connexion du terminal ;
- la figure 3 représente une carte mère d'un terminal de paiement selon la présente divulgation ;
- la figure 4 représente une carte mère d'un terminal de paiement selon la présente divulgation, accompagnée d'une carte optionnelle
- la figure 5 est une vue de face d'un demi boitier inférieur comprenant des orifices d'accès aux éléments de connexion adapté à la carte mère de la figure 3.
- la figure 6 est une vue de face d'un demi boitier inférieur comprenant des orifices d'accès aux éléments de connexion adapté à la carte mère de la figure 4.

### 5. Mode de réalisation

Pour pallier au moins certains inconvénients des terminaux de l'art antérieur, le principe général de la présente divulgation consiste à regrouper, de manière intelligente, les composants du terminal de paiement au sein d'une architecture, nouvelle et inventive, qui offre les avantages d'un terminal de paiement fixe et la compacité d'un terminal de paiement mobile. On note que la présente technique est décrite en relation avec un terminal de paiement fixe. Cependant, il est tout à fait envisageable, et envisagé, d'effectuer un tel regroupement de connecteurs dans le cadre d'un terminal de paiement mobile, la différence se situant au niveau des types de composants à intégrer. Il en résulterait alors un terminal de paiement mobile encore plus compact que les terminaux de paiement mobiles existants.

Pour ce faire, les inventeurs ont eu l'idée de regrouper les emplacements des différentes fonctions du terminal de paiement. Ce regroupement à la différence du regroupement existant, permet d'une part d'éviter d'avoir deux trappes. Ce regroupement permet également d'améliorer de manière sensible l'ergonomie : l'insertion des cartes SAM et SIM au sein du terminal de paiement est plus facile, notamment du fait que l'architecture proposée permet d'éviter l'empilement des connecteurs, comme cela est le cas souvent des terminaux de l'art antérieur.

Ainsi, les inventeurs ont eu l'idée d'ordonner les composants selon leur taille : les composants sont assemblés sur la carte mère en fonction de la hauteur desdits composants, de sorte que les composants de plus grande hauteur soient situés à une première extrémité de la carte et les composants de plus petite hauteur soit situés à une deuxième extrémité de la carte.

En règle générale, la carte de circuit imprimé prend sensiblement la forme d'un rectangle. Selon la divulgation, elle est divisée en au moins une première zone et au moins une deuxième zone, la première zone comprenant des composants dont la hauteur excède un seuil déterminé. Ce seuil peut par exemple se situer aux alentours de un centimètre à deux centimètres. Il correspond à des composants de connexion filaire.

La deuxième zone comprend des composants de connexion de cartes SIM ou SAM. Comme on le verra plus tard, la hauteur de ces composants est adaptée.

La carte de circuit imprimé comprend en outre au moins une troisième zone comprenant des composants dont la hauteur se situe en deçà d'un plafond prédéterminé. Il s'agit des composants les moins épais, comme par exemple le connecteur de carte à puce (carte de paiement) ou encore un processeur de sécurité. Ce seuil, de l'ordre de 0,1 à 0,5 centimètre, est calculé en fonction de la hauteur prise par une future carte optionnelle, comme cela est décrit postérieurement.

La carte de circuit imprimé comprend ainsi en outre au moins un connecteur de carte optionnelle. La carte de circuit imprimé est conformée pour recevoir, au-dessus d'une zone recevant des composants dont la hauteur se situe en deçà d'un plafond prédéterminé, une carte optionnelle connectée à un connecteur spécifique de la carte de circuit imprimé.

La hauteur des composants des composants de connexion de cartes SIM ou SAM de la deuxième zone est calculée de sorte que les composants de connexion de cartes SIM ou SAM de la deuxième zone ait une hauteur sensiblement identique à des composants de même nature, qui sont montés sur une carte optionnelle qui connectée à un connecteur spécifique de la carte de circuit imprimé située dans une zone, au voisinage de la deuxième zone.

La divulgation comprend également un demi-boitier inférieur d'un terminal de paiement caractérisé en ce qu'il comprend un unique plan d'insertion d'une pluralité de module de traitement de données (SIM, SAM, Micro SD). Ainsi, l'ergonomie d'utilisation du terminal est grandement facilitée.

Ainsi, les inconvénients de l'art antérieur sont résolus grâce notamment à la conception d'une nouvelle carte mère pour le terminal de paiement. Cette carte mère, de forme essentiellement rectangulaire comprend plusieurs zones de fixation des composants électroniques. Plus particulièrement, selon la présente divulgation, les composants électroniques de hauteurs similaires ou équivalentes sont regroupés entre eux. Ce regroupement permet d'étager la carte et de définir, dans ce mode de réalisation, trois zones de fixation des composants électroniques ou des connecteurs. La première zone de fixation est dite zone [A], est occupée par les prises de connexion des câbles. La deuxième zone de fixation est dite zone [B], est occupée par les connecteurs SIM ou SAM. La troisième zone de fixation est dite zone [C], est occupée par des composants électroniques de faible hauteur.

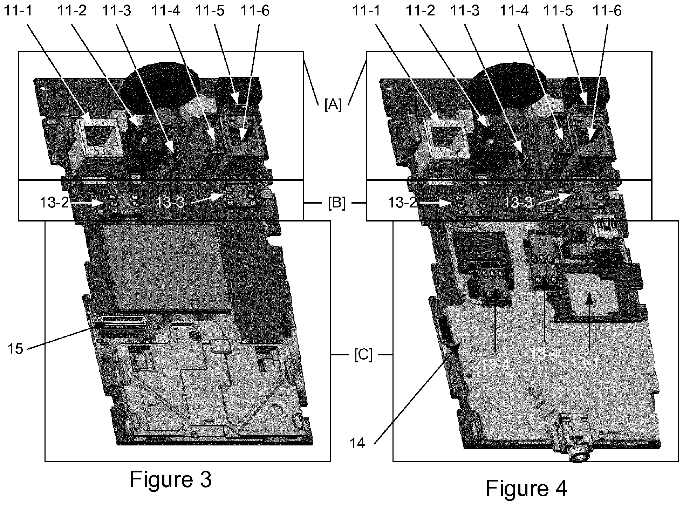

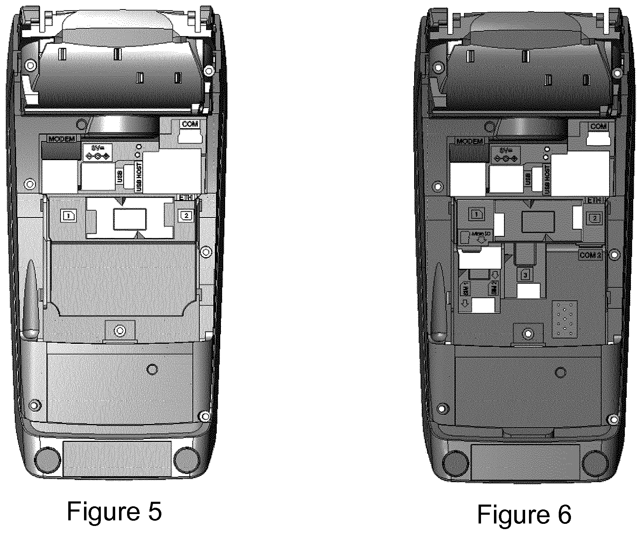

Les figures 3 et 4 exposent l'architecture générale de la carte mère de la présente divulgation. Les éléments communs aux figures présentées précédemment conservent des références numériques communes. Ainsi, dans ce mode de réalisation, la zone [A] de la carte est dédiée aux connecteurs externes (11-1, 11-2, 11-3, 11-4, 11-5, 11-6) (alimentation, communication par Modem, Ethernet, USB, RS232). La zone [B] est dédiée aux deux connecteurs SAM (13-2, 13-3). La zone [C] est occupée par des composants de faible hauteur, elle dégage une place importante pour une seconde carte (carte extension) qui est optionnelle. L'avantage est double : d'une part la hauteur de composants diminue progressivement : les composants les plus gros sont situés en haut de la carte. Lorsque la carte est positionnée dans le terminal de paiement, cette disposition des composants au niveau du haut de la carte correspond à la position du rouleau de papier de l'imprimante. Ainsi, les composants les plus gros se situent dans une zone qui est déjà épaisse de par la présence du rouleau de papier du terminal de paiement. Dès lors, il est possible de rendre le terminal plus compact et donc d'agir avec une plus grande liberté sur l'aspect esthétique du terminal. Par ailleurs, la zone [B], dans laquelle les connecteurs SAM et/ou SIM (13-2, 13-3) sont agencés, est située à proximité de la zone [A]. L'avantage est ainsi de n'avoir besoin que d'une seule et unique trappe pour l'accès à l'ensemble des connecteurs et des prises de connexion des câbles. Le regroupement des composants des zones [A] et [B] permet d'affiner le terminal. En effet, comme les composants électroniques les plus épais sont situés à proximité du rouleau d'impression le reste du terminal peut être affiné, ce qui n'est pas le cas des terminaux de l'art antérieur. Par ailleurs, comme la zone [C] est réservée aux composants électroniques de faible hauteur, il est possible d'ajouter une carte optionnelle (14) au niveau de cette zone [C]. La présence d'une telle carte optionnelle dans les terminaux de l'art antérieur est une chose commune. En revanche, du fait de l'absence d'une architecture optimisée, cette carte optionnelle de l'art antérieure est plus ou moins responsable de l'embonpoint du terminal de paiement. Dans l'architecture proposée, en revanche, cette carte optionnelle (14) est placée en zone [C] (c.f. figure 6) à l'aide d'un connecteur (15) prévu à cet effet. D'une manière générale, une carte optionnelle comprend par exemple des connecteurs SAM ou SIM supplémentaires (13-4), un connecteur micro SD (13-1). La carte optionnelle peut également comprendre des fonctions de communication complémentaires telles que des modules de communication sans fil (WIFI, Bluetooth et GPRS). Ainsi, dans le cas où le terminal est équipé de deux cartes électroniques (une carte mère et une carte optionnelle), la carte extension est située en dessous de la carte unité centrale, placée parallèlement et connectée à celle-ci. Il en résulte que la présence de la carte extension) à cet endroit (zone [C]) permet que les zones [A] et [B] de la carte mère conservent l'ensemble des fonctions déjà implémentées :
- l'alimentation ;
- la communication par Modem RJ11;
- la communication par voie Ethernet RJ45 ;
- l'USB ;
- la communication série RS232 ;
- les cartes SAM1 et SAM2.

En d'autres termes, une seule et même carte mère peut être utilisée pour construire plusieurs versions du terminal de paiement. Dans le cas d'un terminal en version de base, la carte d'extension n'est pas ajoutée. Dans le cas d'un terminal en version améliorée, la carte d'extension est simplement ajoutée sur le connecteur prévu à cet effet.

En fonction des modes de réalisation, la carte optionnelle est équipée de connecteurs sur ses deux faces permettant d'adjoindre d'autres fonctionnalités au terminal de paiement par la présence des connecteurs et liaisons :
- SAM3 ;
- SIM1 et SIM2 ;
- Une seconde liaison RS232 ;
- Une mémoire au format micro SD.

La disposition des connecteurs placés sur la carte extension est également choisie judicieusement pour permettre un accès ergonomique à toutes ces liaisons sans n'en rendre aucune inaccessible par l'utilisation d'une ou plusieurs autres. Plus particulièrement, selon une caractéristique particulière, la hauteur des connecteurs SAM et/ou SIM et/ou micro SD, tant de la carte mère que de la carte d'extension, est choisie de sorte que l'ensemble des connecteurs (carte mère et carte d'extension) soit situé dans un même plan. Ainsi, le demi boitier inférieur, qui recouvre la carte mère et la carte optionnelle présente un unique plan d'insertion des cartes SIM et/ou SAM et/ou micro SD. À la différence du terminal de l'art antérieur, il n'est donc plus nécessaire de respecter un ordre d'insertion des différentes cartes. Par ailleurs, étant dans un même plan d'insertion, la visibilité de chaque connecteur est plus grande et l'ergonomie est améliorée. Plus particulièrement, la hauteur des connecteurs SAM de la carte mère (13-2, 13-3) est arbitrairement élevée afin de se situer dans le même plan que les connecteurs (13-1, 13-4) de la carte optionnelle lorsque celle-ci est ajoutée.

Les figures 5 et 6 exposent deux versions du demi-boitier inférieur du terminal de paiement dans deux modes de réalisation distincts : le premier mode de réalisation, figure 5, porte sur un demi-boitier destinée à un terminal sans carte optionnelle ; le deuxième mode de réalisation, figure 6, porte sur un demi-boitier destinée à un terminal avec présence d'une carte optionnelle dans le terminal. Le demi-boitier inférieur de la figure 5 comprend une ouverture pour une prise RJ11, une ouverture pour une prise RJ45, une ouverture pour une prise d'alimentation, une ouverture pour l'insertion d'un câble USB, une ouverture pour l'insertion d'un câble mini USB ; Il comprend également une ouverture pour deux cartes SAM.

Le demi-boitier inférieur de la figure 6 comprend en outre une ouverture pour une première carte SIM, une ouverture pour une deuxième carte SIM et une ouverture pour une troisième carte SAM. L'ouverture pour la carte micro SD est située sur le côté droit et permet d'introduire cette carte plus facilement. Le demi boitier enveloppant ces cartes et ces connexions permet avantageusement de recouvrir intimement ces connecteurs, d'offrir un guidage simplifié des mémoires SAM et µSD, de porter en clair le marquage des différentes liaisons, afin d'éviter les erreurs de positionnement ou d'insertion.

Le demi-boitier est issu d'un moule permettant la possibilité de mouler des pièces dans les différentes versions correspondant à la présence ou non de la carte optionnelle. Ceci rend la fabrication de ce demi-boitier bien plus économique. Ainsi, à l'aide de cette technique et de cette architecture, la fabrication de l'un ou l'autre des deux modèles de terminal est moins coûteuse.

## Revendications

1. Carte de circuit imprimé principale pour un terminal de paiement sur laquelle est assemblée une pluralité de composants, dite carte mère, **caractérisé en ce que** lesdits composants de ladite pluralité de composants sont assemblés sur ladite carte mère en fonction de la hauteur desdits composants, de sorte que les composants de plus grande hauteur soient situés à une première extrémité de la carte et les composants de plus petite hauteur soient situés à une deuxième extrémité de la carte, la hauteur desdits composants diminuant progressivement de la première extrémité à la deuxième extrémité, ladite carte de circuit imprimé prenant sensiblement la forme d'un rectangle divisé en au moins une première zone ([A]) et au moins une deuxième zone ([B]), ladite première zone ([A]) comprenant des composants dont la hauteur excède un seuil déterminé,
lesdits composants de la première zone ([A]) étant des composants de connexion filaires (11-1,...,11-6), ladite deuxième zone ([B]) comprenant des composants de connexion de cartes SIM et/ou SAM (13-2, 13-3, 13-4), lesdits composants de connexion de cartes étant configurés pour définir un même plan d'insertion de cartes avec un demi-boitier inférieur du terminal de paiement.

2. Carte de circuit imprimé selon la revendication 1, **caractérisée en ce qu'**elle comprend en outre au moins une troisième zone ([C]) comprenant des composants dont la hauteur se situe en deçà d'un plafond prédéterminé.

3. Carte de circuit imprimé selon la revendication 2, **caractérisée en ce qu'**elle comprend en outre au moins un connecteur (15) de carte optionnelle.

4. Carte de circuit imprimé selon la revendication 1, **caractérisée en ce qu'**elle est conformée pour recevoir, au-dessus d'une zone recevant des composants dont la hauteur se situe en deçà d'un plafond prédéterminé, une carte optionnelle (14) connectée à un connecteur (15) spécifique de la carte de circuit imprimé.

5. Carte de circuit imprimé selon la revendication 1, **caractérisé en ce que** la hauteur des composants de connexion de cartes SIM ou SAM (13-2, 13-3) de ladite deuxième zone ([B]) est calculée de sorte que lesdits composants de connexion de cartes SIM ou SAM (13-2, 13-3) de ladite deuxième zone ([B]) ait une hauteur sensiblement identique à des composants de même nature (13-1, 13-4), qui sont montés sur une carte optionnelle (14) connectée à un connecteur (15) spécifique de la carte de circuit imprimé située dans une zone ([C]), au voisinage de ladite deuxième zone ([B]).

6. Terminal de paiement **caractérisé en ce qu'**il comprend une carte de circuit imprimé selon l'une quelconque des revendications 1 à 5.

7. Terminal de paiement selon la revendication 6, **caractérisé en ce que** ledit terminal comprend un demi-boîtier inférieur comprenant des ouvertures situées à des emplacements correspondant auxdits composants de connexion filaire et audits composants de connexion de carte.

## Patentansprüche

1. Hauptleiterplatte für ein Zahlungsterminal, auf der mehrere Komponenten montiert sind, die Hauptplatine genannt wird, **dadurch gekennzeichnet, dass** die Komponenten der mehreren Komponenten auf der Hauptplatine entsprechend der Höhe der Komponenten derart montiert sind, dass die Komponenten von größter Höhe an einem ersten Ende der Platine angeordnet sind und die Komponenten von kleinster Höhe an einem zweiten Ende der Platine angeordnet sind, wobei die Höhe der Komponenten schrittweise von dem ersten Ende zu dem zweiten Ende abnimmt, wobei die Leiterplatte im Wesentlichen die Form eines Rechtecks aufweist, das in mindestens eine ersten Bereich ([A]) und mindestens einen zweiten Bereich ([B]) unterteilt ist, wobei der erste Bereich ([A]) Komponenten aufweist, deren Höhe einen bestimmten Schwellenwert überschreitet, wobei die Komponenten des ersten Bereichs ([A]) drahtgebundene Komponenten (11-1, ..., 11-6) sind, wobei der zweite Bereich ([B]) Verbindungskomponenten für SIM-Karten und/oder SAM-Karten (13- 2, 13-3, 13-4) aufweist, wobei die Karten-Verbindungskomponenten konfiguriert sind, um eine gleiche Karteneinsteck-Ebene mit einer unteren Gehäusehälfte des Zahlungsterminals zu definieren.

2. Leiterplatte nach Anspruch 1, **dadurch gekennzeichnet, dass** sie ferner mindestens einen dritten Bereich ([C]) aufweist, der Komponenten aufweist, deren Höhe unterhalb einer vorbestimmten Obergrenze liegt.

3. Leiterplatte nach Anspruch 2, **dadurch gekennzeichnet, dass** sie ferner mindestens einen Verbinder (15) einer optionalen Platine aufweist.

4. Leiterplatte nach Anspruch 1, **dadurch gekennzeichnet, dass** sie ausgebildet ist, um über einem Bereich, der Komponenten aufnimmt, deren Höhe unterhalb einer vorbestimmten Obergrenze liegt, eine optionale Platine (14) aufzunehmen, die mit einem spezifischen Verbinder (15) der Leiterplatte verbunden ist.

5. Leiterplatte nach Anspruch 1, **dadurch gekennzeichnet, dass** die Höhe der Verbindungskomponenten für SIM- oder SAM-Karten (13-2, 13-3) des zweiten Bereichs ([B]) derart berechnet ist, dass die Verbindungskomponenten für SIM- oder SAM-Karten (13-2, 13-3) des zweiten Bereichs ([B]) eine Höhe aufweisen, die im Wesentlichen mit Komponenten derselben Art (13-1, 13-4) identisch ist, die auf einer optionalen Platine (14) montiert sind, die mit einem spezifischen Verbinder (15) der Leiterplatte verbunden ist, die in einem Bereich ([C]) in der Nähe des zweiten Bereichs ([B]) angeordnet ist.

6. Zahlungsterminal, **dadurch gekennzeichnet, dass** es eine Leiterplatte nach einem der Ansprüche 1 bis 5 aufweist.

7. Zahlungsterminal nach Anspruch 6, **dadurch gekennzeichnet, dass** das Terminal eine untere Gehäusehälfte aufweist, die Öffnungen aufweist, die an Stellen angeordnet sind, die den drahtgebundenen Komponenten und den Karten-Verbindungskomponenten entsprechen.

## Claims

1. Printed circuit board for a payment terminal on which a plurality of components is assembled, called a motherboard, **characterized in that** said components of said plurality of components are assembled on said motherboard according to the height of said components so that the components of greater height are situated at a first end of the board and the components of smaller height are situated at a second end of the board, the height of the component decreasing progressively from the first end to the second end, said Printed circuit board taking substantially the shape of a rectangle divided into at least one first area ([A]) and at least one second area ([B]), said first area ([A]) comprising components whose height exceeds a determined threshold,
said components of the first area ([A]) being wired connection components (11-1,...,11-6) said second area ([B]) comprising SIM card and/or SAM card connection components (13-2, 13-3,13-4), said card connection component being configured for defining a same card insertion plane with a lower half-casing of the payment terminal.

2. Printed circuit board according to claim 1, **characterized in that** it furthermore comprises at least one third area ([C]) comprising components whose height is situated below a predetermined ceiling.

3. Printed circuit board according to claim 2, **characterized in that** furthermore comprises at least one optional board connector (15).

4. Printed circuit board according to claim 1, **characterized in that** is shaped to receive, above an area receiving components whose height is situated below a predetermined ceiling, an optional board connected to a specific connector of the printed circuit board.

5. Printed circuit board according to claim 1, **characterized in that** height of the connection components of the SIM or SAM connection cards (13-2, 13-3) of said second area ([B]) is calculated so that said connection components of the SIM or SAM cards (13-2, 13-3) of said second area ([B]) have a height substantially identical to the height of the components of a same nature (13-1, 13-4), that are mounted on an optional board (14) connected to a specific connector (15) of the printed circuit board situated in an area ([C]), in the vicinity of said second area ([B]).

6. Payment terminal comprising a printed circuit board according to any one of the claims 1 to 5.

7. Payment terminal according to claim 6, **characterized in that** said terminal comprises a Lower half-casing comprising openings located at locations corresponding to wired connection components and to said card connection components.
